# EUROPEAN PATENT APPLICATION

(11) **EP 4 105 063 A1**
(43) Date of publication of application: **21.12.2022**
(21) Application number: 21218033.5
(22) Date of filing: 29.12.2021
(51) Int. Cl.: B60L 53/30, H05K 7/14

(54) **MODULAR HIGH-POWER OFF-BOARD CHARGER**

(30) Priority: 15.06.2021 CN 202110658215
(71) Applicant: Wanbang Digital Energy Co., Ltd., Changzhou, Jiangsu (CN); Wanbang Star Charge Technology Ltd., Changzhou, Jiangsu (CN)
(72) Inventor: Ke, Mengfu, Changzhou (CN); CHEN, CHIEH-KAI, Changzhou (CN); Fan, Hao, Changzhou (CN)
(74) Representative: Sun, Yiming

(57) **Abstract**

The disclosure relates to a modular high-power off-board charger. The charger includes an AC module, a DC module, a rectifier module and a wire harness module. The AC module is provided with an AC module connector, the DC module is provided with a DC module connector, the rectifier module is provided with a rectifier module connector, and the wire harness module is provided with an AC wire harness connector docked with the AC module connector, a DC wire harness connector docked with the DC module connector, and a rectifier wire harness connector docked with the rectifier module connector. The AC wire harness connector, the DC wire harness connector and the rectifier wire harness connector are electrically connected in the wire harness module. The modular high-power off-board charger of the disclosure can achieve onsite installation for one person alone, and there is no need to carry out connection, thus the installation is simple, convenient and fast.

## Description

### FIELD OF THE DISCLOSURE

The disclosure relates to the technical field of automobile charging, in particular to a modular high-power off-board charger.

### DESCRIPTION OF RELATED ART

With global warming and environmental degradation, people's demand for clean energy has risen. As the main means of transportation for people's daily travel, the exhaust gas emitted by automobiles is one of the main sources of environmental pollution. New energy electric vehicles as replacement for fuel vehicles are an effective way to solve the pollution problem. The function of a charger is similar to that of a fuel dispenser in a gas station, and the charger serves as a kind of charging device that provides electric energy to drive an electric vehicle.

Chargers can be categorized into on-board chargers and off-board chargers according to different installation positions. The on-board charger refers to chargers fixedly installed on electric vehicles, and the main function thereof is to supply power to the batteries for electric vehicles safely, rapidly and conveniently. The off-board charger refers to a device that is fixedly installed outside the electric vehicle and is connected to an AC grid to provide DC power for the rechargeable energy storage system such as the power battery of the electric vehicle.

According to the charging method, chargers can be classified into AC chargers and DC chargers. The DC charger is also referred to as DC fast charging. Compared with the AC charger, the DC charger has the advantages of shorter charging time and higher efficiency. However, the high-power DC charger currently available on the market all has shortcomings such as large size, heavy weight, difficult installation, complicated wiring, inconvenient maintenance, and poor scalability.

### SUMMARY OF THE DISCLOSURE

In order to solve the complicated wiring problem in the conventional off-board charger, the disclosure provides a modular high-power off-board charger. The wiring is completed in the wire harness module and assembled directly on site without wiring, which is convenient and fast for installation.

The technical scheme of the disclosure is as follows.

A modular high-power off-board charger includes:
an alternating current (AC) module, he AC module being provided with an AC module connector;
a direct current (DC) module, the DC module being provided with a DC module connector;
a rectifier module, the rectifier module being provided with a rectifier module connector;
a wire harness module, the wire harness module being provided with an AC wire harness connector docked with the AC module connector, a DC wire harness connector docked with the DC module connector, and a rectifier wire harness connector docked with the rectifier module connector. The AC wire harness connector, the DC wire harness connector and the rectifier wire harness connector are electrically connected in the wire harness module.

Further, the AC module, the DC module, and the rectifier module are stacked and assembled in sequence from bottom to top, and the wire harness module is arranged on the lateral side of the AC module, the DC module, and the rectifier module. A gun-hanging module is mounted on the AC module.

Further, there are multiple rectifier modules, and the multiple rectifier modules are sequentially stacked above the DC module.

Moreover, there are two wire harness modules, which are an AC wire harness module and a DC wire harness module, respectively. The rectifier wire harness connector includes a first rectifier wire harness connector and a second rectifier wire harness connector, and the AC wire harness module is provided with the AC wire harness connector and a plurality of the first rectifier wire harness connectors. The DC wire harness module is provided with the DC wire harness connector and a plurality of the second rectifier wire harness connectors. The AC wire harness module and the DC wire harness modules are respectively pushed to the AC module, DC module and the rectifier modules from a lateral side for installation. In the installing process, the AC wire harness connector, the DC wire harness connector and the rectifier wire harness connector are respectively and correspondingly connected to the AC module connector, the DC module connector and the rectifier module connector.

Furthermore, an AC copper busbar is provided in the AC wire harness module, and the AC copper busbar is connected to the AC wire harness connector and the plurality of the first rectifier wire harness connectors through a wire harness. A DC copper busbar is provided in the DC wire harness module, and the DC copper busbar is connected to the DC wire harness connector and the plurality of the second rectifier wire harness connectors through a wire harness.

Moreover, the AC copper busbar and the DC copper busbar are provided in multiple, and wire harness frames of the AC wire harness module and the DC wire harness module are all formed with a stepped mounting part. The plurality of AC copper busbars are respectively arranged on different stepped surfaces of the stepped mounting part of the AC wire harness module, and the plurality of DC copper busbars are respectively arranged on different stepped surfaces of the stepped mounting part of the DC wire harness module.

Further, each of the rectifier modules is provided with a relay therein, and these relays are electrically connected to a controller, and the controller performs power distribution by controlling the on and off of the relay.

Moreover, a mounting opening is provided on each of the wire harness frames.

Moreover, the off-board charger further includes a base module formed by four box-shaped profiles assembled together, and a reinforcing structure is also mounted in the base module.

Further, the base module, the AC module, the DC module, and the rectifier module are mounted and fixed through a quick mounting structure. The quick mounting structure includes a mounting protrusion and a mounting cap. The mounting protrusion and the mounting cap are correspondingly provided with threads, and the mounting cap is sleeved on the mounting protrusion and is locked and fastened with the threads through a screw.

By adopting the above technical solution, a modular high-power off-board charger provided by the disclosure has the following advantageous effects compared with the conventional technology.
1. The modular high-power off-board charger of the disclosure is composed of multiple functional modules, and the weight of each functional module is set to be ≤20kg, so that an individual alone is capable of completing on-site installation, thereby saving the use of cranes, forklifts and other large tooling equipment, which significantly reduces the waste of manpower and material resources.
2. The functional modules of the disclosure can be manufactured in a factory in a streamlined manner, which improves equipment production efficiency and shortens equipment production cycle.
3. In the disclosure, the DC module is arranged on the AC module, the gun-hanging module is arranged on the AC module, and a human-computer interaction module is arranged on the DC module, so that the charger can satisfy high demands and is adaptable in domestic and international environments, and the operation is more convenient and user-friendly.
4. In the disclosure, by providing the wire harness module, and by providing the connector on the wire harness module to be correspondingly connected to the connector on the AC module, the DC module, and the rectifier module, and the connection between the AC module and the rectifier module as well as the connection between the DC module and the rectifier module are all completed before shipping, the installation can be carried out directly on site, and no wiring and wire arrangement are required. As such, the efficiency of production and installation is significantly improved.
5. The disclosure can achieve power expansion by changing the number of rectifier modules, and it is only required to continue stacking on the original rectifier modules during expansion, which is very convenient and can save development and production cycles when the same series of products are promoted and user's needs are changed. In addition, the disclosure is equipped with a relay in each rectifier module, which can realize different power switching and improve the efficiency of equipment utilization.
6. The base module of the disclosure is assembled with four box-shaped profiles, which is light in weight and high in strength, convenient for on-site assembly, and saves production cost and production cycle.
7. The quick mounting structure of the disclosure can realize quick positioning and installation for the base module, the AC module, the rectifier module and the DC module, and saves time for on-site installation.

### BRIEF DESCRIPTION OF THE DRAWINGS

FIG. 1 is a schematic view of the overall structure of a conventional off-board charger.
FIG. 2 is a schematic view of an electrical scheme for a conventional off-board charger.
FIG. 3 is a schematic view of an electrical scheme for an off-board charger of this embodiment.
FIG. 4 is a schematic view of the overall structure of an off-board charger of this embodiment.
FIG. 5 is a schematic structural view of an AC module connector and a first rectifier module connector of this embodiment.
FIG. 6 is a schematic structural view of an AC wire harness module of the embodiment.
FIG. 7 is a partial enlarged view of portion A in FIG. 6.
FIG. 8 is a front view of the AC wire harness module of this embodiment.
FIG. 9 is a side view of the AC wire harness module of this embodiment.
FIG. 10 is a top view of the AC wire harness module of this embodiment.
FIG. 11 is a schematic structural view of a DC module connector and a second rectifier module connector of this embodiment.
FIG. 12 is a schematic structural view of a DC wire harness module of this embodiment.
FIG. 13 is a top view of the DC wire harness module of this embodiment.
FIG. 14 is a schematic structural view of a base module of this embodiment.
FIG. 15 is a schematic structural view of the AC module of this embodiment.
FIG. 16 is a schematic structural view of an AC input element of this embodiment.
FIG. 17 is a schematic structural view of the DC module of this embodiment.
FIG. 18 is a schematic structural view of a DC output element of this embodiment.
FIG. 19 is a schematic structural view of a rectifier module of this embodiment.
FIG. 20 is a schematic structural view of a quick mounting structure of this embodiment.

Wherein,
off-board charger 01, integral housing 02, circuit breaker 03, AC contactor 04, charging gun 05;
AC module 1, AC module connector 11, AC module frame 12, AC input element 13, AC module communication connector 15; DC module 2, DC module connector 21, DC module frame 22, DC output element 23, connecting interface 24, DC module communication connector 25; rectifier module 3, first rectifier module connector31, second rectifier module connector32; wire harness module 4, AC wire harness module 41, AC wire harness frame 411, first rectifier wire harness connector 412, AC wire harness connector 413, AC copper busbar 414, first AC copper busbar 4141, second AC copper busbar 4142, third AC copper busbar 4143, fourth AC copper busbar 4144, DC wire harness communication connector 415, DC wire harness module 42, DC wire harness frame 421, second rectifier wire harness connector422, DC wire harness connectors 423, DC copper busbar 424, first DC copper busbar 4241, second DC copper busbar 4242, third DC copper busbar 4243, fourth DC copper busbar 4244, AC wire harness communication connector 425, wire harness 43, connecting hole 44, stepped mounting part 45, mounting opening46; gun-hanging module 5; human-computer interaction module 6; base module 7, box-shaped profile 71, reinforcing structure72; quick mounting structure 8, mounting protrusion 81, mounting cap 82, threads 83, chamfer 84; top cover 9.

### DESCRIPTION OF EMBODIMENTS

The technical solutions in the embodiments of the disclosure will be clearly and completely described below in conjunction with the accompanying drawings in the embodiments of the present disclosure. Clearly, the described embodiments are only a part of the embodiments of the disclosure, rather than all the embodiments. The following description of at least one exemplary embodiment is actually only illustrative, and in no way serves as any limitation to the disclosure and its application or use. Based on the embodiments of the disclosure, all other embodiments obtained by those of ordinary skill in the art without creative work shall fall within the scope to be protected by the disclosure.

In the description of the disclosure, it should be understood that orientation terms such as "front, back, up, down, left, right", "lateral, perpendicular, vertical, horizontal" and "top, bottom", etc. indicating the orientation or the positional relationship normally refer to the direction or positional relationship shown in the figure, and they are simply used for the convenience of describing the disclosure and simplifying the description. Unless otherwise stated, these directional terms do not indicate or imply that the descried device or element must have a specific orientation or be constructed and operated in a specific orientation, so they should not be construed as a limitation to the scope to be protected by the disclosure. The orientation term "inside and outside" refers to the inside and outside relative to the contour of each component itself.

For ease of description, spatial relative terms can be used here, such as "above...", "on top of...", "on the top surface of...", "upper", etc., to describe the spatial positional relationship between one device or feature and other devices or features as shown in the figure. It should be understood that the spatially relative terms are intended to encompass different orientations in use or operation other than the orientation of the device described in the figure. For example, if the device in the drawing is inverted, then a device described as "above other devices or structures" or "on top of other devices or structures" will then be positioned as "below other devices or structures" or "under other devices or structures". Thus, the exemplary term "above...." can include both orientations "on top of...." and "under...". The device can also be positioned in other different ways (rotated by 90 degrees or in other orientations), and the relative description of the space used here will be explained accordingly.

In addition, it should be noted that the use of terms such as "first" and "second" to define parts is only for the convenience of distinguishing the corresponding parts. Unless otherwise stated, the above terms have no special meaning and therefore should not be construed as a limitation to the scope to be protected by the disclosure.

The purpose of the disclosure is to provide a stacked modular high-power off-board charger to solve the problems of existing high-power DC chargers, such as large size, heavy weight, difficult installation, complicated wiring, and inconvenient maintenance. It is possible to achieve on-site installation for one person alone, and there is no need to carry out connection on site, the installation is simple, convenient and fast. A specific description will be given below through specific embodiments.

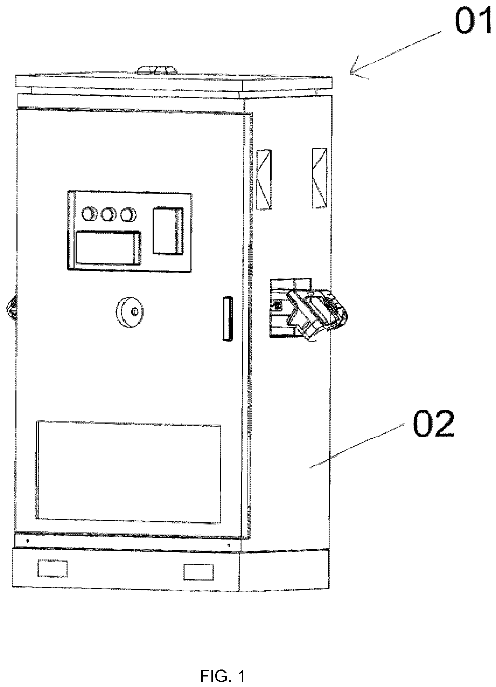

As shown in FIG. 1, the conventional off-board charger 01 is an integrated structure, in which the AC part, the rectifier part and the DC part are all formed in an integral housing 02, and physical and electrical connections are realized in the integral housing 02. In this way, the entire off-board charger 01 is formed as a whole, which is large in size and heavy in weight, and needs to be mounted on site by professional tooling such as cranes and forklifts. The installation is not convenient, and the rectifier part needs to be added when an expansion, e.g., increase output power, is required subsequently, and the integral off-board charger 01 is difficult or even impossible to expand.

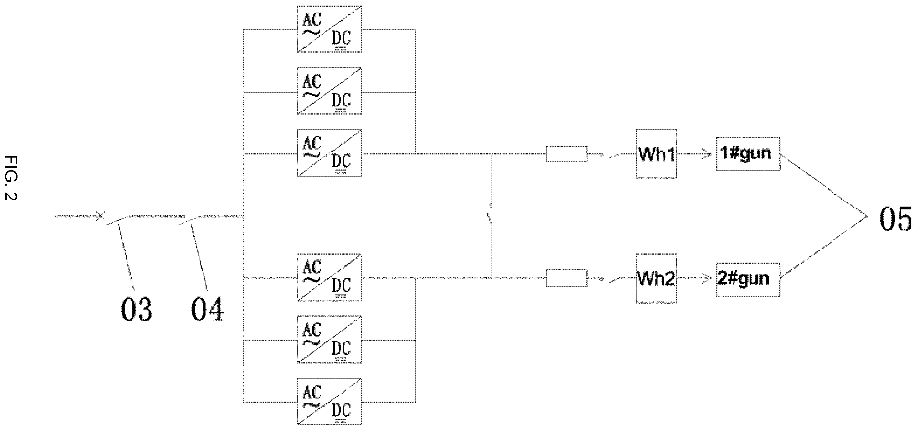

FIG. 2 shows the primary electrical scheme of the conventional off-board charger 01. The AC power input from the grid passes through the circuit breaker 03 and the AC contactor 04 and then enters the rectifier part. The rectifier part converts the AC power into DC power and then outputs the power to each charging guns 05, and each charging gun 05 can charge vehicles.

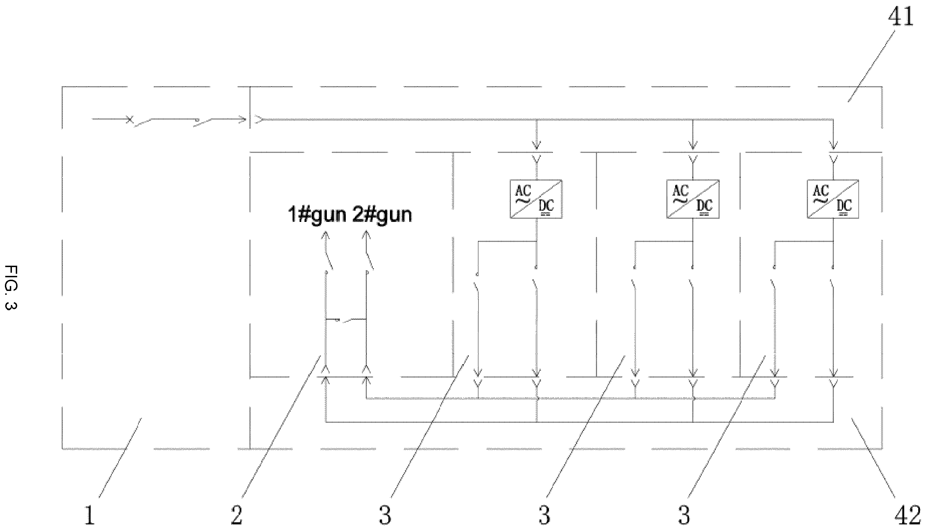

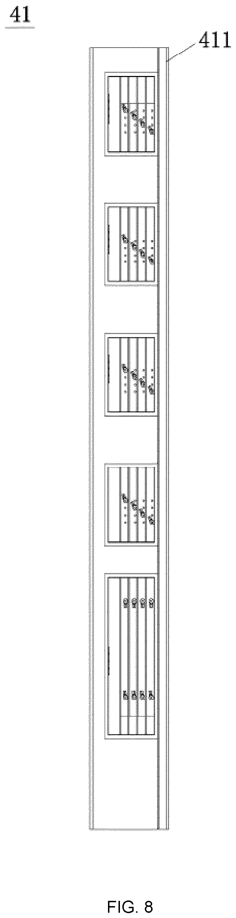

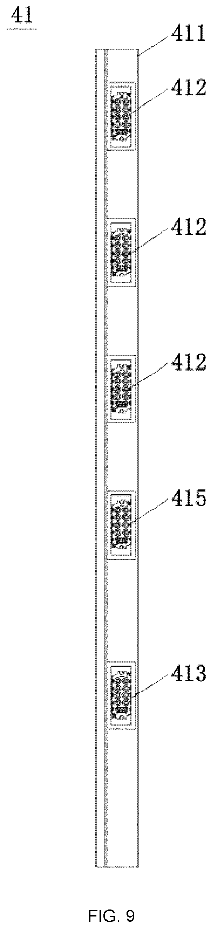

As shown in FIG. 3 to FIG. 13, this embodiment divides the above-mentioned primary electrical scheme according to functions, which is divided into functional modules such as an AC module 1, a DC module 2, rectifier modules 3, and a wire harness module 4 in sequence. Each functional module can be assembled on site, and the connection between the AC module 1 and the rectifier modules 3, and the electrical connection between the DC module 2 and the rectifier modules 3 are completed in the wire harness module 4. Then, the wire harness module 4 is assembled. With the corresponding insertion between the connector on the wire harness module 4 and the connectors on the AC module 1, the DC module 2 and the rectifier modules 3, the whole electrical connection can be realized. Specifically, the AC module 1 is provided with an AC module connector 11, the DC module 2 is provided with a DC module connector 21, and each of the rectifier modules 3 is provided with a rectifier module connector. The wire harness module 4 includes a wire harness frame and multiple sets of wire harness 43. The multiple sets of wire harnesses 43 are arranged in the wire harness frame, and the wire harness frame is provided with an AC wire harness connector 413 docked with the AC module connector 11, a DC wire harness connector 423 docked with the DC module connector 21, and a rectifier wire harness connector docked with the rectifier module connector. The AC wire harness connector 413, the DC wire harness connector 423 and the rectifier wire harness connector are electrically connected directly or indirectly in the wire harness frame through the wire harness 43.

In the conventional technology, for any one of a stacked off-board charger, a drawer-type off-board charger or an assembled off-board charger, a very complicated wiring operation is required when installation is carried out on site, especially when there are a lot of rectifier modules, the wires are more complicated. Under the circumstances, the on-site installation efficiency is significantly affected. In this embodiment, connectors are provided on the AC module 1, the DC module 2 and each rectifier module 3, and then a wire harness module 4 is provided. The wire harness module 4 is also provided with a corresponding connector. The two connectors can be a male connector in cooperation with a female connector. During an on-site installation, it is only required to push the wire harness module 4 in to make the connector on the wire harness module 4 to be correspondingly inserted into the connectors on the AC module 1, the DC module 2 and the rectifier modules 3. The wiring connection between the AC module 1, the DC module 2 and the rectifier modules 3 is completed in the wire harness module 4, and the wiring is completed before shipping, so that wiring needs not be carried out during on-site installation. The installation is very convenient, the efficiency is improved, and the risk of erroneous wiring can be avoided during the on-site installation.

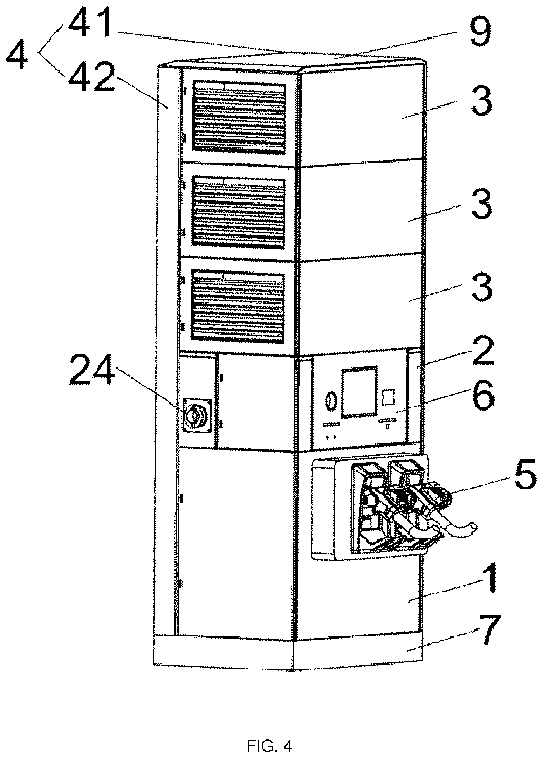

In order to realize on-site installation with one person alone, the embodiment adopts a stacking assembly method to arrange various functional modules, and the weight of each functional module is set to be ≤20kg. As shown in FIG. 4, the AC module 1, the DC module 2, and the rectifier modules 3 of this embodiment are stacked and assembled in sequence from bottom to top. The top cover 9 is mounted on the rectifier module 3 at the top. Furthermore, the AC module 1 is provided with the gun-hanging module 5, the DC module 2 is fixed with a human-computer interaction module 6, and the wire harness module 4 is arranged on the lateral side of the AC module 1, the DC module 2 and the rectifier modules 3.

In the conventional technology, the DC module is generally arranged at the top, that is, the AC module, the rectifier module, and the DC module are arranged from bottom to top, and then the gun-hanging module is arranged on the DC module or the rectifier module, but such installation is not friendly to people with disabilities. The height of the gun-hanging module and the human-computer interaction module is high, which makes it impossible for people with disabilities to pull out the gun, hang the gun, and operate on the screen. Moreover, in the United States, for example, regulations pertaining to people with disabilities are established to satisfy their needs for charging.

In order to conform to the relevant regulations of various people in various countries, in this embodiment, the DC module 2 is arranged above the AC module 1, the rectifier modules 3 are arranged above the DC module 2, then the gun-hanging module 5 is arranged on the AC module 1, and the human-computer interaction module 6 is fixed on the DC module 2. In this manner, the height of the gun-hanging module 5 and the human-computer interaction module 6 are relatively low so as to satisfy the operation requirement of people with disabilities. Besides, the connecting interface 24 for connecting the gun cable on the DC module 2 is very close to the gun-hanging module 5, so that the gun cable is shorter and lighter, making it easier to pull the gun out and put the gun back, and the operation is more user-friendly.

Preferably, multiple rectifier modules 3 can be provided according to power requirements. In this embodiment, three rectifier modules 3 are provided, and the three rectifier modules 3 are stacked on top of the DC module 2 in sequence. Power expansion can be achieved by adding the rectifier module 3. When adding the rectifier module 3, it is only required to continue stacking new rectifier module 3 on the original rectifier module 3, which makes it convenient to realize power expansion.

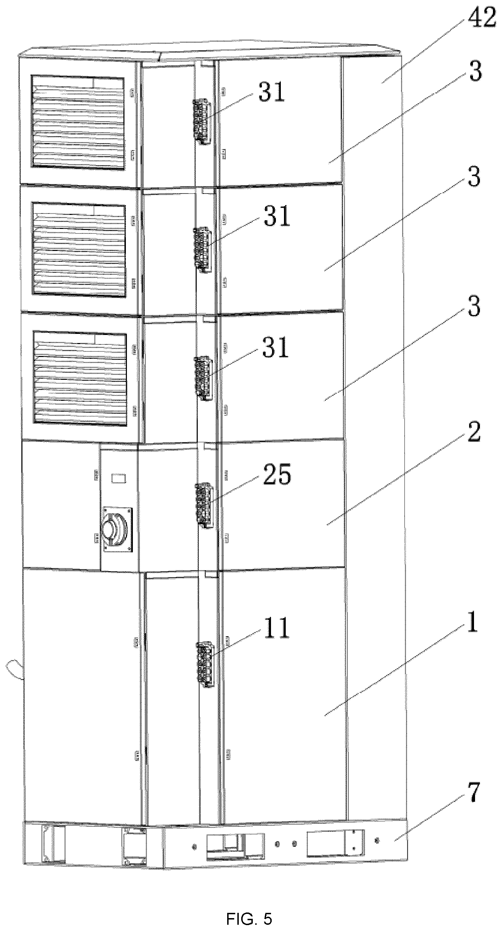

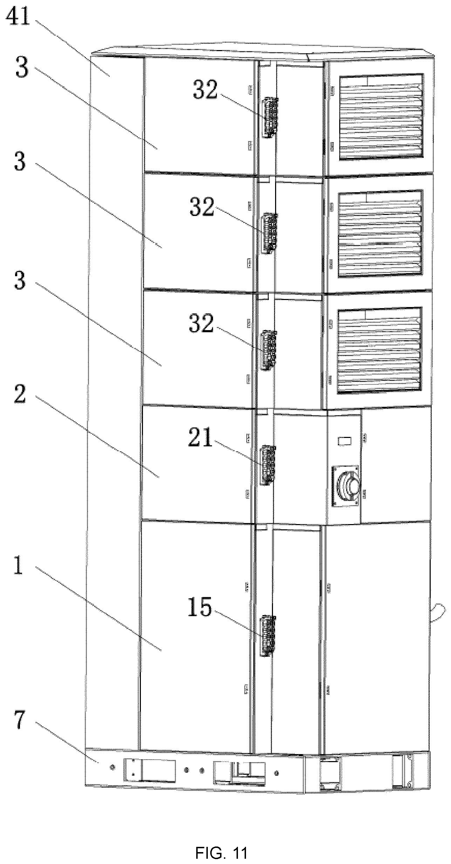

Furthermore, there are two wire harness modules 4 in this embodiment, namely an AC wire harness module 41 and a DC wire harness module 42. The AC module 1 is connected to the three rectifier modules 3 through the AC wire harness module 41, and the three rectifier modules 3 are connected to the DC module 2 through the DC wire harness module 42. The DC module 2 is connected to a charging gun through a gun cable. Specifically, as shown in FIG. 5 and FIG. 11, in this embodiment, an AC module connector 11 is provided on the AC module 1, and the DC module connector 21 is provided on the DC module 2. There are three sets of first rectifier module connectors 31 and three sets of second rectifier module connectors 32 respectively on both sides of the rectifier module 3. The first rectifier module connectors 31 and the AC module connector 11 are arranged on one side of the charger, and the second rectifier module connectors 32 and the DC module connector 21 are arranged on the other side of the charger.

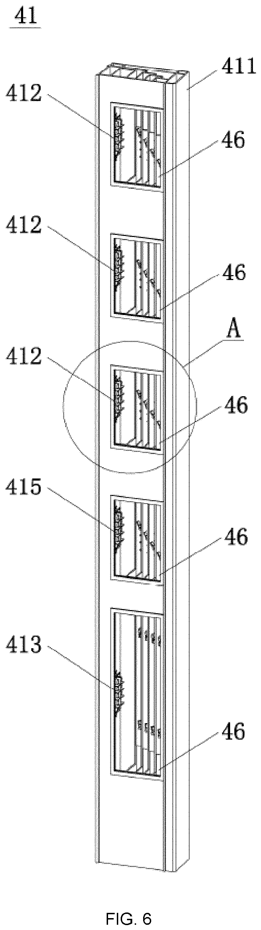

Furthermore, the AC wire harness module 41 of this embodiment includes an AC wire harness frame 411 and a plurality of wire harnesses 43, as shown in FIG. 6. The AC wire harness frame 411 is a long strip as a whole, and is provided with three sets of first rectifier wire harness connectors 412 and a set of AC wire harness connector 413 thereon. The three sets of first rectifier wire harness connectors 412 respectively correspond to the three sets of first rectifier module connectors 31 in FIG. 5, and the AC wire harness connector 413 corresponds to the AC module connector 11 in FIG. 5. The AC wire harness module 41 is pushed from the lateral side to the AC module 1, the DC module 2 and the rectifier modules 3 for installation. During the installation of pushing the AC wire harness module 41 in, the AC wire harness connector 413 and the AC module connector 11 are connected, and the first rectifier wire harness connectors 412 and the first rectifier module connectors 31 are correspondingly connected through insertion.

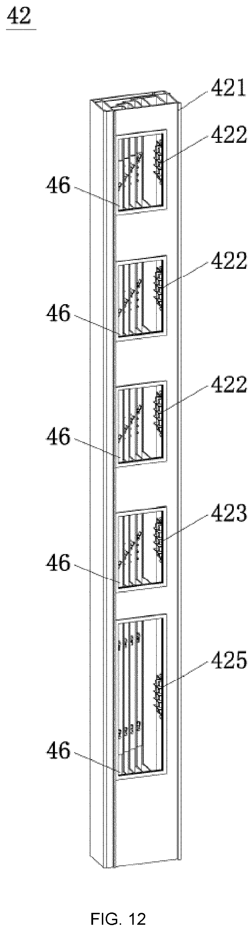

Further, the DC wire harness module 42 of this embodiment includes a plurality of DC wire harnesses 43, as shown in FIG. 12, the DC wire harness frame 421 is a long strip as a whole, and three sets of second rectifier wire harness connectors 422 and a set of DC wire harness connector 423 are provided thereon. The three sets of second rectifier wire harness connectors 422 respectively correspond to the three sets of second rectifier module connectors 32 in FIG. 11, and the DC wire harness connector 423 corresponds to the DC module connectors 21 in FIG. 11. The DC wire harness module 42 is pushed from the lateral side to the AC module 1, the DC module 2 and the rectifier module 3 for installation. During the installation of pushing the DC wire harness module 42, the DC wire harness connector 423 and the DC module connector 21 are connected, and the second rectifier wire harness connectors 422 and the second rectifier module connectors 32 are respectively connected through insertion.

In this way, in this embodiment, two wire harness modules 4 are provided, and the AC wire harness connector 413 and each of the first rectifier wire harness connectors 412 can be connected through the wire harness 43 in the AC wire harness module 41, and the DC wire harness connector 423 and each of the second rectifier wire harness connectors 422 can be connected through the wire harness 43 in the DC wire harness module 42. In this manner, the wire connection is more convenient and intuitive. Imagine that if these wire connections are completed in a wire harness module, the wire harness will inevitably be messy, resulting in difficulties for wiring. Moreover, it is also difficult to sort out the wire harness during maintenance, resulting in difficulty in maintenance.

Although the wire harness is provided in the wire harness module, multiple rectifier modules 3 are required when the charger power is large, and when the number of the rectifier module 3 is increased, the wires between the AC module 1 and the rectifier module 3 as well as between the DC module 2 and the rectifier module 3 are increased, and the number of required connectors is increased as well. For example, in this embodiment, three rectifier modules 3 are adopted, and one AC module 1 needs to be correspondingly connected to three rectifier modules 3. As a result, the number of AC wire harness connector 413 and AC module connector 11 will be large. Similarly, one DC module 2 also needs to be correspondingly connected to three rectifier modules 3. As a result, the number of DC wire harness connectors 423 and the DC module connectors 21 will also be large. On the one hand, there is limited space on each wire harness module, DC module 2 and AC module 1, it is not possible to provide many connectors, and the cost of the connectors is also high. On the other hand, the increase in the wire harness makes the wiring more troublesome, and the wire harness is very messy in appearance.

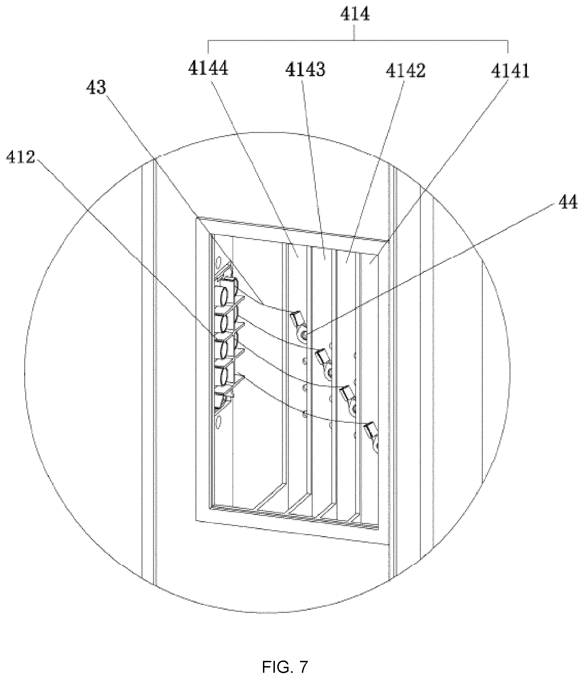

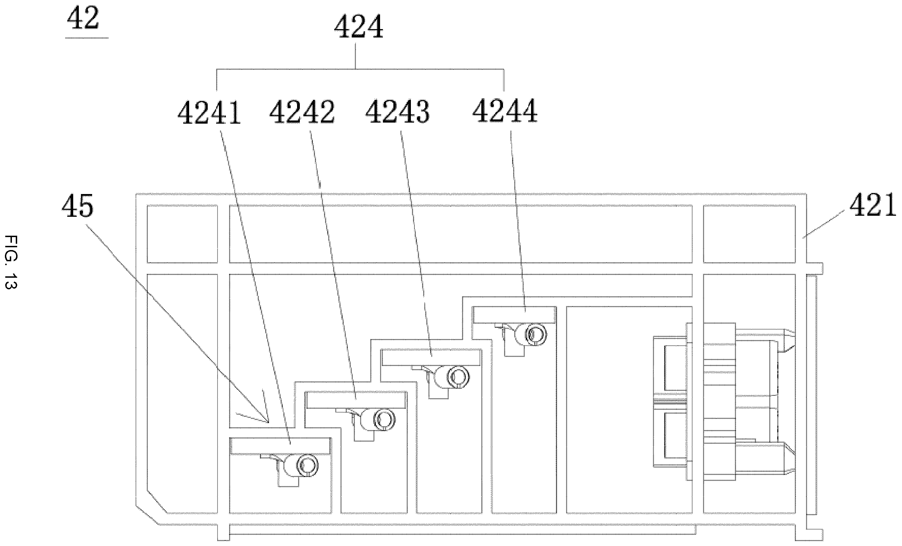

To solve this problem, in this embodiment, a plurality of elongated AC copper busbars 414 are provided in the AC wire harness module 41, and a plurality of elongated DC copper busbars 424 are provided in the DC wire harness module 42. Specifically, as shown in FIG. 7 to FIG. 10, the AC copper busbar 414 includes a first AC copper busbar 4141, a second AC copper busbar 4142, a third AC copper busbar 4143, and a fourth AC copper busbar 4144, which respectively correspond to the AC three-phase power L1, L2 and L3 and the ground PE at the input end of the charger. As shown in FIG. 13, the DC copper busbar 424 includes a first DC copper busbar 4241, a second DC copper busbar 4242, a third DC copper busbar 4243, and a fourth DC copper busbar 4244, which respectively correspond to the first power output positive DC+, the first power output negative DC-, the second power output positive DC+, and the second power output negative DC- (corresponding to two charging guns) at the output end. Further, a connecting hole 44 is provided on each copper busbar to connect to a corresponding connector, as shown in FIG. 6 to FIG. 7. Taking the fourth AC copper busbar 4144 as an example, it is a long strip with four sets of connecting holes 44. Four connecting holes are provided in a set. The heights of the four sets of connecting holes 44 respectively match the heights of the three sets of first rectifier wire harness connectors 412 and the AC wire harness connector 413. In this way, the AC wire harness connector 413 can be connected to lowest set of connecting holes 44 of the fourth AC copper busbar 4144 through the wire harness 43, and then the remaining three sets of connecting holes 44 of the fourth AC copper busbar 4144 are connected to each of the first rectifier wire harness connectors 412 through the wire harness 43. Other copper busbars are also provided with connecting holes 44 for connection in this way. As such, the number of connectors and wire harnesses is reduced, making it convenient to carry out wire harness connection, and the connected wire harness is very organized and beautiful, and the subsequent maintenance work can be carried out conveniently.

As shown in FIG. 6 and FIG. 12, in this embodiment, both the AC wire harness frame 411 and the DC wire harness frame 421 are provided with a plurality of mounting openings 46, and each of the mounting openings 46 is set corresponding to the height of each connector to perform the installation for each connector, fixation for each copper busbars and connection of wire harness, etc.

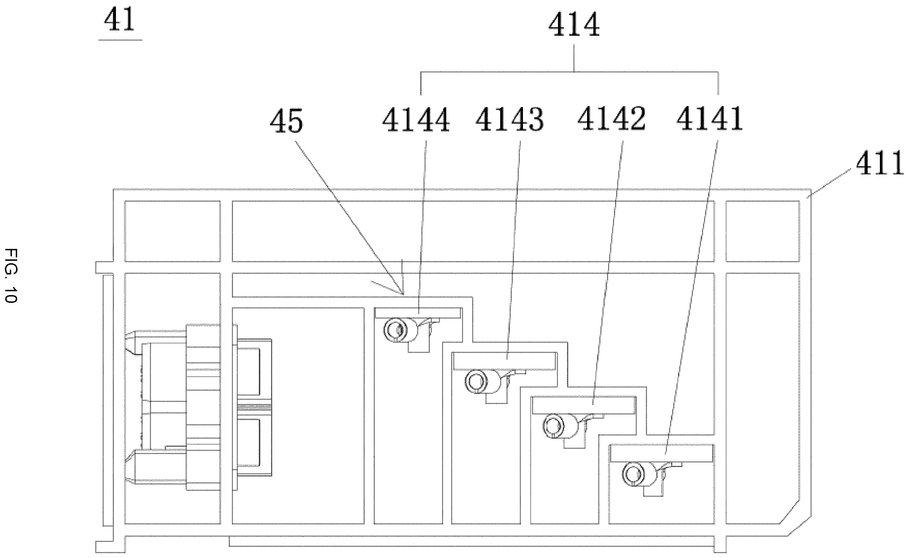

In order to further increase the creepage distance between the copper busbars, as shown in FIG. 10, in this embodiment, a stepped mounting part 45 is provided in the AC wire harness frame 411. The first AC copper busbar 4141, the second AC copper busbar 4142, the third AC copper busbar 4143 and the fourth AC copper busbar 4144 are respectively mounted on different stepped surfaces of the stepped mounting part 45. Similarly, as shown in FIG. 13, a stepped mounting part 45 is also provided in the DC wire harness frame 421. The first DC copper busbar 4241, the second DC copper busbar 4242, the third DC copper busbar 4243, and the fourth DC copper busbar 4244 are respectively mounted on different stepped surfaces of the stepped mounting part 45. In this way, the creepage distance between the copper busbars can be satisfied, and the strength of the AC wire harness frame 411 and the DC wire harness frame 421 can be improved. It should be noted that both the AC wire harness frame 411 and the DC wire harness frame 421 of this embodiment are made of lightweight, insulating, high-strength and corrosion-resistant materials.

Each of the above-mentioned connectors not only has high-power terminals for power input or output, but also has low-power terminals for communication, etc. The modules communicate with each other through the low-power terminals on each connector. As shown in FIG. 5, in this embodiment, the DC module 2 is also provided with a DC module communication connector 25. As shown in FIG. 6, the AC wire harness module 41 is further correspondingly provided with a DC wire harness communication connector 415. These two connectors are not used for power output, but used for communication with other modules. As shown in FIG. 11, there is also an AC module communication connector 15 on the AC module 1, as shown in FIG. 12, and an AC wire harness communication connector 425 is further correspondingly provided on the DC wire harness module 42. Similarly, the two connectors are not used for power output, but used for communication with other modules. In this way, the space of the AC module 1 and the DC module 2 is effectively utilized, and the connectors are reasonably arranged, so that the number of connectors can meet the requirements of communication and the like.

Further, in this embodiment, each of the rectifier modules 3 is provided with a relay, and these relays are electrically connected to a controller, and the controller controls the on and off of the relays to change the number of rectifier modules 3 involved for output, so that power can be distributed.

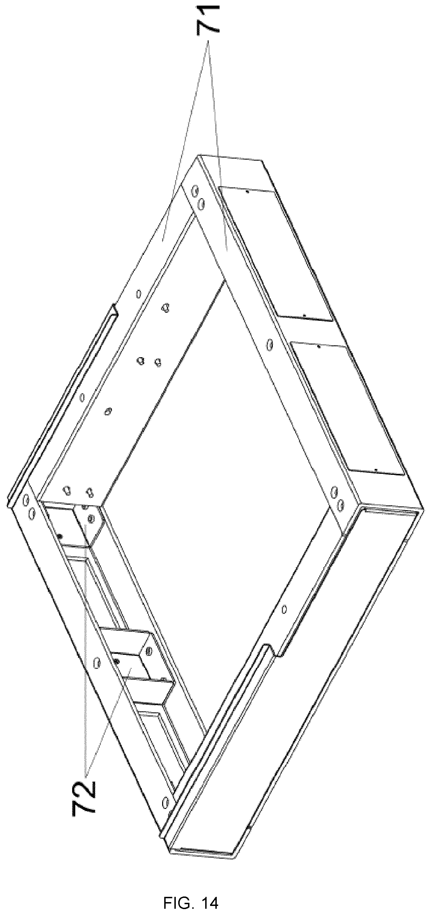

As shown in FIG. 14, the off-board charger of this embodiment further includes a base module 7, which is arranged below the AC module 1. The base module 7 is formed by four box-shaped profiles 71 assembled together through fasteners such as bolts. In this way, the above design solves the shortcomings of conventional base module, such as heavy weight and requirement of a lot of welding. Besides, when carrying out on-site installation, only one person is required to remove the package, and bolts can be used for fixation in sequence to complete the installation. As such, it is possible to satisfy on-site installation with one person alone. Furthermore, each box-shaped profile 71 is made of light and high-strength materials, and the reinforcing structures 72 are also provided in the base module 7, so that the base module 7 has a very light weight and sufficient strength, which prevents the base module 7 from deforming or even tearing caused by structural resonance of charger and other factors.

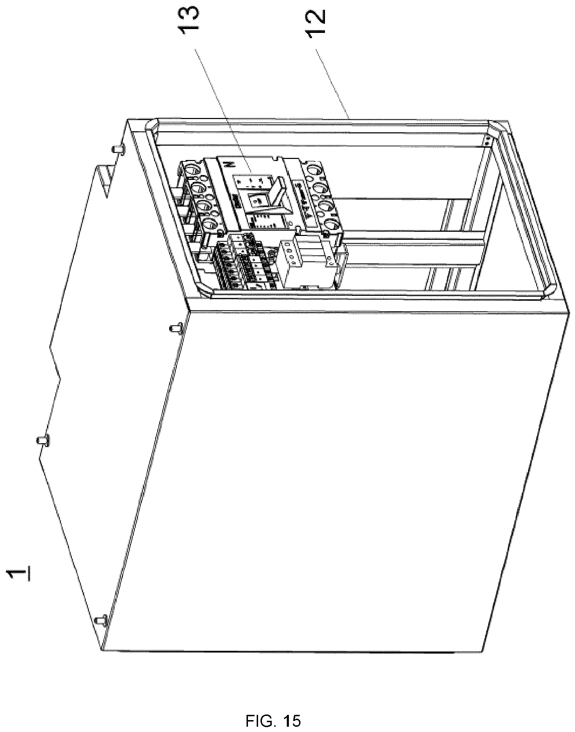

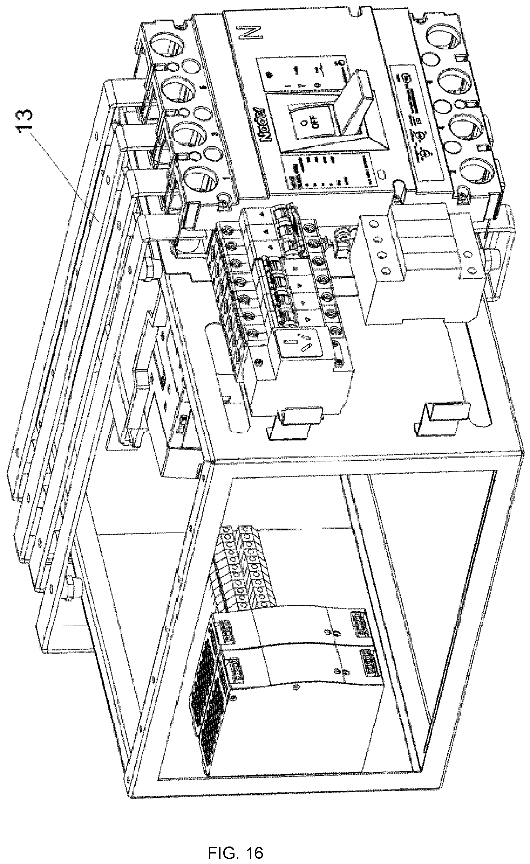

As shown in FIG. 15 to FIG. 16, the AC module 1 of this embodiment includes an AC module frame 12 and an AC input element 13. The AC input element 13 is an AC input element and its supporting structure, and the AC module frame 12 is provided with a mounting rail for the AC input element 13 therein. The weight of the AC input element 13 is set to be ≤20kg, which is convenient for on-site installation, and only one installer is required before shipping to install and fix the AC input element 13 into the AC module frame 12.

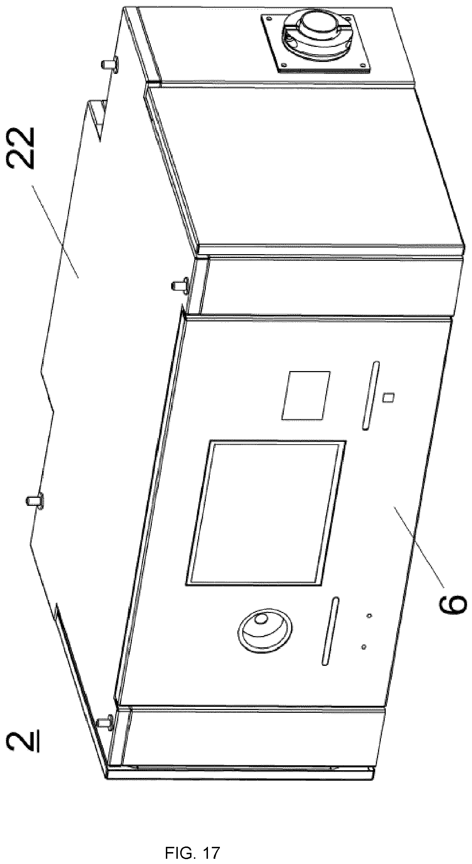

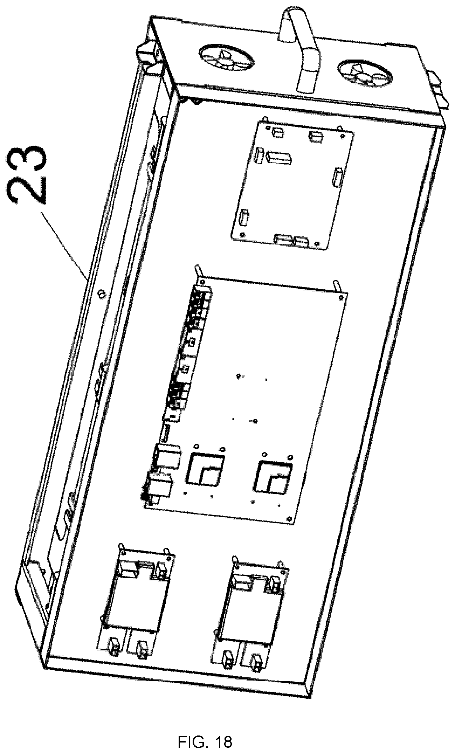

As shown in FIG. 17 to FIG. 18, the DC module 2 of this embodiment includes a DC module frame 22 and a DC output element 23. The DC module 2 is provided with a human-computer interaction module 6, and the DC output element 23 is a DC output element and its supporting structure. The DC module frame 22 and the AC module 1 are fixed. The DC module frame 22 is provided with left and right position-limiting element surfaces therein as the supporting structure for the DC output element 23. The human-computer interaction module 6 includes a display screen, a card sensing panel, a charging status light and other components. The human-computer interaction module 6 is fixed on the front mounting surface of the DC module frame 22.

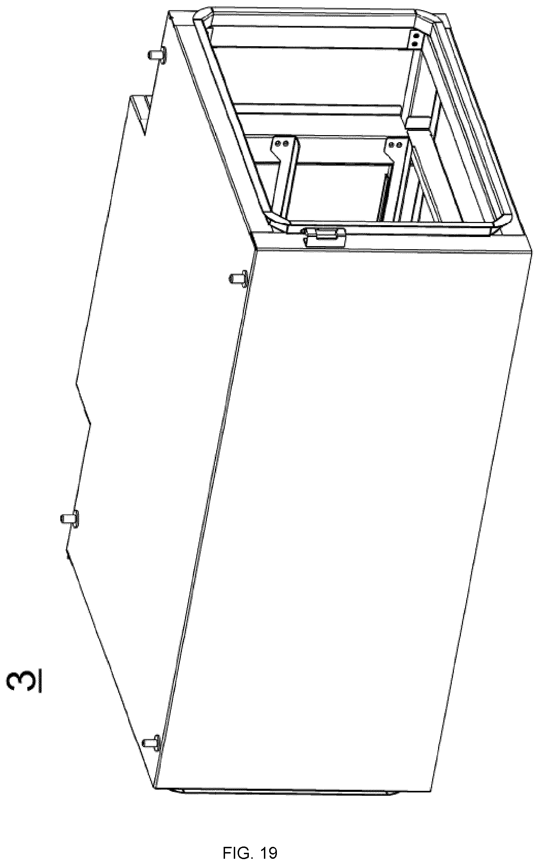

As shown in FIG. 19, the rectifier module 3 of this embodiment is equipped with a power supply module therein, and the rectifier module is functioned to realize the conversion between alternating current and direct current. This rectifier module 3 is the important part for heat dissipation of the whole machine. A heat dissipation fan can be provided to introduce the cool air outside the cabinet as the inlet air, and make the outlet air as the hot air after the power supply module is heated, so that the hot air can be exhausted out of the cabinet, thereby realizing heat dissipation. It should be noted that when adding or decreasing the rectifier module 3, each wire harness module 4 needs to be changed accordingly.

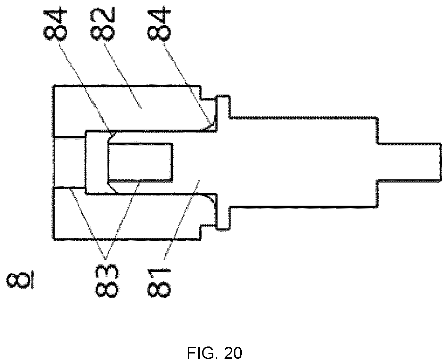

The base module 7, the AC module 1, the DC module 2, and the rectifier module 3 of this embodiment are all mounted and fixed through a quick mounting structure 8. As shown in FIG. 20, the quick mounting structure 8 includes a mounting protrusion 81 and a mounting cap 82. The mounting protrusion 81 and the mounting cap 82 are correspondingly provided with threads 83. The mounting cap 82 is sleeved on the mounting protrusion 81 and then locked and fastened by screws and the threads 83. A chamfer 84 is provided at the outer periphery of the mounting protrusion 81 and the inner periphery of the mounting cap 82, so that fast guide can be realized during assembly. Taking the installation of the base module 7 and the AC module 1 as an example, a plurality of mounting protrusions 81 are provided on the upper part of the base module 7, and a plurality of mounting caps 82 are correspondingly provided at the bottom of the AC module frame 12, and the AC module 1 is stacked on the base module 7 and fastened through screws.

The modular high-power off-board DC charger of this embodiment subverts the installation and transportation methods of the conventional DC charger. The overall on-site installation includes assembling the base module 7, the AC module 1, the DC module 2, the rectifier module 3, the gun-hanging module 5, and the human-computer interaction module 6 in sequence from bottom to top, as well as inserted installation of various wire harness modules and the AC module 1, the DC module 2, and the rectifier module 3. The whole installing process is simple, convenient and fast, the installation can be completed by one person alone, the specific installation steps are as follows.
S1: Removing the packaging, assembling the base module 7, and mounting and fixing the base module 7 on the cement pier of the whole machine.
S2: Mounting the AC module 1 on the base module 7 through the quick mounting structure 8.
S3: Mounting and fixing the DC module 2 on the AC module 1 through the quick mounting structure 8.
S4: Mounting and fixing the rectifier module 3 on the DC module 2 through the quick mounting structure 8.
S5: According to power customization requirements, continuously installing the rectifier module 3.
S6: Mounting the gun-hanging module 5 on the AC module 1, and mounting the human-computer interaction module 6 on the DC module 2.
S7: Pushing and fixing the AC wire harness module 41 and the DC wire harness module 42.

It can be obtained from the above that the modular high-power off-board charger provided in this embodiment not only can realize on-site installation with one person alone, but also requires no wiring during installation, and therefore the installation is convenient and fast.

The above are only the preferred specific embodiments of the disclosure, but the scope to be protected by the disclosure is not limited thereto. The equivalent replacement or change made by anyone familiar with the technical field within the technical scope disclosed by the disclosure according to the technical solution and disclosure concept thereof of the disclosure shall fall within the scope to be protected by the disclosure.

## Claims

1. A modular high-power off-board charger, **characterized by** comprising:
an alternating current (AC) module (1), the AC module (1) being provided with an AC module connector (11);
a direct current (DC) module (2), the DC module (2) being provided with a DC module connector (21);
a rectifier module (3), the rectifier module (3) being provided with a rectifier module connector; and
a wire harness module (4), the wire harness module (4) being provided with an AC wire harness connector (413) docked with the AC module connector (11), a DC wire harness connector (423) docked with the DC module connector (21), and a rectifier wire harness connector docked with the rectifier module connector, wherein the AC wire harness connector (413), the DC wire harness connector (423) and the rectifier wire harness connector are electrically connected in the wire harness module (4).

2. The modular high-power off-board charger according to claim 1, **characterized in that** the AC module (1), the DC module (2), and the rectifier module (3) are stacked and assembled in sequence from bottom to top, and the wire harness module (4) is arranged on a lateral side of the AC module (1), the DC module (2), and the rectifier module (3), and a gun-hanging module(5) is mounted on the AC module (1).

3. The modular high-power off-board charger according to claim 2, **characterized in that** a number of the rectifier module (3) is multiple, and the multiple rectifier modules (3) are sequentially stacked above the DC module (2).

4. The modular high-power off-board charger according to claim 3, **characterized in that** a number of the wire harness module (4) is two, which are an AC wire harness module (41) and a DC wire harness module (42) respectively, the rectifier wire harness connector comprises a first rectifier wire harness connector (412) and a second rectifier wire harness connector (422), and the AC wire harness module (41) is provided with the AC wire harness connector (413) and a plurality of the first rectifier wire harness connectors (412), the DC wire harness module (42) is provided with the DC wire harness connector (423) and a plurality of the second rectifier wire harness connectors (422), the AC wire harness module (41) and the DC wire harness module (42) are respectively pushed to the AC module (1), the DC module (2) and the rectifier modules (3) from a lateral side for installation.

5. The modular high-power off-board charger according to claim 4, **characterized in that** an AC copper busbar (414) is provided in the AC wire harness module (41), and the AC copper busbar (414) is connected to the AC wire harness connector (413) and the plurality of first rectifier wire harness connectors (412) through a wire harness (43), a DC copper busbar (424) is provided in the DC wire harness module (42), and the DC copper busbar (424) is connected to the DC wire harness connector (423) and the plurality of second rectifier wire harness connectors (422) through the wire harness (43).

6. The modular high-power off-board charger according to claim 5, **characterized in that** the AC copper busbar (414) and the DC copper busbar (424) are provided in multiple, wire harness frames of the AC wire harness module (41) and the DC wire harness module (42) are all formed with a stepped mounting part (45), the plurality of AC copper busbars (414) are respectively arranged on different stepped surfaces of the stepped mounting part (45) of the AC wire harness module (41), and the plurality of DC copper busbars (424) are respectively arranged on different stepped surfaces of the stepped mounting part (45) of the DC wire harness module (42).

7. The modular high-power off-board charger according to any one of claims 3-6, **characterized in that** each of the rectifier modules (3) is provided with a relay therein, and the relays are electrically connected to a controller, and the controller performs power distribution by controlling on and off of the relay.

8. The modular high-power off-board charger according to claim 6, **characterized in that** a mounting opening (46) is provided on each of the wire harness frames.

9. The modular high-power off-board charger according to claim 1, **characterized in that** the off-board charger further comprising a base module (7), the base module (7) is formed by four box-shaped profiles (71) assembled together, and a reinforcing structure (72) is further mounted in the base module (7).

10. The modular high-power off-board charger according to claim 9, **characterized in that** the base module (7), the AC module (1), the DC module (2), and the rectifier module (3) are mounted and fixed through a quick mounting structure (8), the quick mounting structure (8) comprises a mounting protrusion (81) and a mounting cap (82), the mounting protrusion (81) and the mounting cap (82) are correspondingly provided with threads (83), and the mounting cap (82) is sleeved on the mounting protrusion (81) and is locked and fastened with the threads (83) through a screw.
